# EUROPÄISCHE PATENTANMELDUNG

(11) **EP 3 016 474 A1**
(43) Veröffentlichungstag der Anmeldung: **04.05.2016**
(21) Anmeldenummer: 15185637.4
(22) Anmeldetag: 17.09.2015
(51) Int. Cl.: H05B 1/02

(54) **ELEKTRISCHE HEIZUNG UND VERFAHREN ZUM BETRIEB EINER ELEKTRISCHEN HEIZUNG**

(30) Priorität: 27.10.2014 DE 102014221790
(71) Anmelder: Siemens Aktiengesellschaft, 80333 München (DE)
(72) Erfinder: Bach, Christine, 90431 Nürnberg (DE); Haase, Axel, 91052 Erlangen (DE); Schneider, Reinhard, 96049 Bamberg (DE); Stoll, Jürgen, 90768 Fürth (DE); Zinn, Philipp, 91207 Lauf (DE)

(57) **Zusammenfassung**

Die Erfindung betrifft eine elektrische Heizung (4), insbesondere einer Kunststoffformanlage (2), mit einem Strompfad (6), der einen ersten Messabgriff (20), einen zweiten Messabgriff (22), einen Schalter (16) und einen dritten Messabgriff (24) aufweist, die in Reihe geschaltet sind, wobei zwischen den ersten Messabgriff (20) und den zweiten Messabgriff (22) ein Heizelement (14) schaltbar ist. Die elektrische Heizung (4) umfasst zudem einen Diagnosepfad (28), der einen ersten Diagnoseabgriff (30), ein erstes Spannungsmessgerät (52), einen zweiten Diagnoseabgriff (32), ein zweites Spannungsmessgerät (54) und einen dritten Diagnoseabgriff (34) aufweist, die in Reihe geschaltet sind. Der erste Messabgriff (20) ist mittels einer ersten Schutzimpedanz (38) mit dem ersten Diagnoseabgriff (30), der zweite Messabgriff (22) mittels einer zweiten Schutzimpedanz (40) mit dem zweiten Diagnoseabgriff (32) und der dritte Messabgriff (24) mittels einer dritten Schutzimpedanz (42) mit dem dritten Diagnoseabgriff (34) elektrisch kontaktiert. Die Erfindung betrifft ferner ein Verfahren (60) zum Betrieb einer elektrischen Heizung (4).

## Beschreibung

Die Erfindung betrifft einerseits eine elektrische Heizung, insbesondere einer Kunststoffformanlage, mit einem Strompfad, der ein Heizelement aufweist, und andererseits ein Verfahren zum Betrieb einer derartigen elektrischen Heizung.

Lebensmittel, wie Getränke, werden in zunehmendem Maße in Kunststoffbehältern aufbewahrt. Als Kunststoff wird meist ein thermoplastischer Kunststoff verwendet, wie Polyethylenterephthalat (PET). Hierbei werden Platten oder Folien des thermoplastischen Kunststoffs zunächst erhitzt und in einem weiteren Arbeitsschritt in eine bestimmte Form gepresst, beispielsweise mit einer entsprechenden Kontur, Druckluft oder mittels Erzeugung eines Vakuums.

Die Wärmeerzeugung erfolgt meist mittels einer elektrischen Heizung, die ein Heizelement umfasst. Somit ist eine vergleichsweise genaue Einstellung der Temperatur möglich. Als Heizelement wird üblicherweise eine Heizwendel verwendet. Aufgrund eines vergleichsweise hohen elektrischen Widerstands der Heizwendel wird diese bei einem Stromfluss erwärmt und folglich elektrische Energie in thermische Energie umgewandelt. Der elektrische Strom wird meist mittels eines Halbleiterschalters geschaltet, was die Ausbreitung eines Lichtbogens in diesem Bereich vermeidet. Aufgrund des vergleichsweise hohen Stromflusses sowie der vergleichsweise hohen thermischen Belastung ist es möglich, dass der Schalter oder aber das Heizelement beschädigt wird. Hierbei werden beispielsweise einzelne Heizdrähte der Heizwendel kurzgeschlossen, sodass zwar ein Stromfluss weiterhin besteht, jedoch der Widerstand des Heizelements vergleichsweise gering ist. Infolgedessen wird der thermoplastische Kunststoff nicht mehr vollständig erwärmt und ein Umformen ist nicht mehr möglich.

Um eine Beschädigung der zur Umformung herangezogenen Anlage zu vermeiden, ist es daher erforderlich, einen derartigen Ausfall in einer vergleichsweisen kurzen Zeitspanne nach Auftritt der Beschädigung zu erfassen. Damit zudem ein Stillstand der Anlage vergleichsweise kurz ist, ist es ebenfalls erforderlich, den aufgetretenen Fehler vergleichsweise schnell zu identifizieren, also festzustellen, ob der Schalter oder aber das Heizelement beschädigt ist. Hierfür ist meist parallel zu dem Schalter und dem Heizelement ein elektrisches Spannungsmessgerät geschaltet, mittels dessen die elektrische Spannung überwacht wird. Ein vergleichsweise starker Spannungsabfall wird hierbei als Bedingung für die Identifikation einer Beschädigung zumindest eines Bestandteils der elektrischen Heizung herangezogen.

Zur Vermeidung einer Beschädigung des Spannungsmessgerätes aufgrund des vergleichsweise hohen Stromflusses ist dieses galvanisch von dem das Heizelement aufweisenden Stromkreis getrennt. Zur galvanischen Trennung wird meist ein Optokoppler verwendet, der jedoch lediglich eine begrenzte Betriebsdauer aufweist. So unterliegt ein Optokoppler einem vergleichsweise starken Alterungsprozess, weswegen dieser nach bestimmten Zeitintervallen ausgetauscht werden muss, um eine korrekte Funktionsweise des elektrischen Spannungsmessgeräts zu gewährleisten.

Der Erfindung liegt die Aufgabe zugrunde, eine besonders geeignete elektrische Heizung sowie ein besonders geeignetes Verfahren zum Betrieb einer elektrischen Heizung anzugeben, bei denen eine Fehlerdiagnose vorzugsweise verbessert und Kosten insbesondere reduziert sind.

Hinsichtlich der elektrischen Heizung wird diese Aufgabe durch die Merkmale des Anspruchs 1 und hinsichtlich des Verfahrens durch die Merkmale des Anspruchs 10 erfindungsgemäß gelöst. Vorteilhafte Weiterbildungen und Ausgestaltungen sind Gegenstand der jeweiligen Unteransprüche.

Die elektrische Heizung ist zweckmäßigerweise Bestandteil einer Industrieheizanlage, mittels derer beispielsweise Nahrungs- und Genussmittel, Photovoltaikzellen oder aber Automobile bearbeitet oder erstellt werden. Vorzugsweise jedoch dient die elektrische Heizung der Erhitzung von Kunststoffen. Mit anderen Worten ist die elektrische Heizung Bestandteil einer Kunststoffformanlage, mittels derer zweckmäßigerweise thermoplastische Kunststoffe erhitzt und zu bestimmten Formen geformt werden. Folglich werden mittels der Kunststoffformanlage bestimmte aus Kunststoff bestehende Produkte gefertigt. Alternativ ist die elektrische Heizung Bestandteil eines Trocknungsofens. Die elektrische Heizung weist einen Strompfad auf, in den ein Heizelement schaltbar ist. Insbesondere weist der Strompfad das Heizelement auf, zumindest jedoch ist der Strompfad vorgesehen und eingerichtet, dass das Heizelement in den Strompfad geschalten wird. Das Heizelement umfasst zweckmäßigerweise eine Heizwendel, die insbesondere mittels eines Heizwiderstandes erstellt ist. Beispielsweise umfasst der Heizwiderstand einen vergleichsweise hochohmigen Draht, mittels dessen bei einem Stromfluss elektrische Energie in thermische Energie gewandelt wird. Beispielsweise besteht die Heizwendel aus Kanthal oder einer Nickel-Eisen-Legierung.

Der Strompfad weist einen Schalter auf, mittels dessen ein elektrischer Stromfluss durch den Strompfad unterbrochen werden kann. Der Strompfad umfasst zudem einen ersten, zweiten und dritten Messabgriff, wobei der zweite Messabgriff zwischen dem etwaigen Heizelement und dem Schalter angeordnet ist, und wobei das etwaige Heizelement zwischen dem ersten und dem zweiten Messabgriff sowie der Schalter zwischen dem zweiten und dem dritten Messabgriff elektrisch angeordnet ist. Mit anderen Worten sind der erste Messabgriff, das Heizelement, der zweite Messabgriff, der Schalter und der dritte Messabgriff in dieser Reihenfolge in Reihe geschaltet.

Die elektrische Heizung weist ferner einen Diagnosepfad auf, der einen ersten Diagnoseabgriff, einen zweiten Diagnoseabgriff und einen dritten Diagnoseabgriff aufweist, die in Reihe geschaltet sind, wobei zwischen dem ersten Diagnoseabgriff und dem zweiten Diagnoseabgriff ein erstes Spannungsmessgerät und zwischen dem zweiten und dem dritten Diagnoseabgriff ein zweites Spannungsmessgerät elektrisch geschaltet ist. Mit anderen Worten sind im Diagnosepfad der erste Diagnoseabgriff, das erste Spannungsmessgerät, der zweite Diagnoseabgriff, das zweite Spannungsmessgerät und der dritte Diagnoseabgriff in dieser Reihenfolge in Reihe geschaltet.

Der erste Messabgriff ist mittels einer ersten Schutzimpedanz mit dem ersten Diagnoseabgriff, der zweite Messabgriff mittels einer zweiten Schutzimpedanz mit dem zweiten Diagnoseabgriff und der dritte Messabgriff mittels einer dritten Schutzimpedanz mit dem dritten Diagnoseabgriff elektrisch kontaktiert. Mit anderen Worten ist der Diagnosepfad mittels der ersten, zweiten und dritten Schutzimpedanz parallel zu dem Strompfad geschaltet, wobei das erste Spannungsmessgerät mittels der ersten und zweiten Schutzimpedanz parallel zu dem etwaigen Heizelement und das zweite Spannungsmessgerät mittels der zweiten und dritten Schutzimpedanz parallel zu dem Schalter geschaltet ist. Zusammenfassend weist die elektrische Heizung den Strompfad mit dem zum Schalter in Reihe geschalteten Heizelement auf, wobei das erste Spannungsmessgerät mittels der ersten und zweiten Schutzimpedanz zu dem Heizelement und das zweite Spannungsmessgerät mittels der zweiten und der dritten Schutzimpedanz zu dem Schalter parallelgeschaltet ist. Vorzugsweise ist das Heizelement Bestandteil des Strompfads, der den ersten Messabgriff, das Heizelement, den zweiten Messabgriff, den Schalter und den dritten Messabgriff aufweist, die in Reihe geschaltet sind. Beispielsweise weist der Strompfad anstatt des Heizelements einen Anschluss oder einen Stecker für das Heizelement auf.

Mit anderen Worten betrifft die Erfindung die elektrische Heizung, insbesondere der Kunststoffformanlage, mit dem Strompfad, der den in Reihe geschalteten ersten Messabgriff, zweiten Messabgriff und dritten Messabgriff aufweist, wobei zwischen dem ersten Messabgriff und dem zweiten Messabgriff das Heizelement und zwischen dem zweiten Messabgriff und dem dritten Messabgriff der Schalter geschaltet ist, und mit dem Diagnosepfad, der den in Reihe geschalteten ersten Diagnoseabgriff, zweiten Diagnoseabgriff und dritten Diagnoseabgriff aufweist, wobei zwischen dem ersten Diagnoseabgriff und dem zweiten Diagnoseabgriff das erste Spannungsmessgerät und zwischen dem zweiten Diagnoseabgriff und dem dritten Diagnoseabgriff das zweite Spannungsmessgerät geschaltet ist, und wobei der erste Messabgriff mittels einer ersten Schutzimpedanz mit dem ersten Diagnoseabgriff, der zweite Diagnoseabgriff mittels der zweiten Schutzimpedanz mit dem zweiten Diagnoseabgriff und der dritte Messabgriff mittels der dritten Schutzimpedanz mit dem dritten Diagnoseabgriff elektrisch kontaktiert ist.

Folglich ist keines der Spannungsmessgeräte mittels eines Optokopplers mit dem Strompfad gekoppelt, so dass zumindest in diesem Bereich der Optokoppler entfallen kann. Folglich sind dessen spezifische Eigenschaften, wie die spezielle Ansteuerung, eine etwaige Nichtlinearität der erfassten Messsignale sowie die vergleichsweise ausgeprägten Alterungserscheinungen nicht vorhanden und somit bei der Herstellung der elektrischen Heizung nicht zu berücksichtigen. Folglich sind die Herstellungskosten reduziert. Zudem ist die Zuverlässigkeit erhöht, da die Schutzimpedanzen eine größere Zuverlässigkeit und eine erhöhte Betriebsdauer als ein Optokoppler aufweisen. Insbesondere wird bei Betrieb der Strompfad mittels eines elektrischen Wechselstroms beaufschlagt, wobei die Anschlusspunkte der elektrischen Stromquelle den jeweiligen Endpunkt des Strompfades bilden. Beispielsweise wird ein sinusförmiger Wechselstrom verwendet, dessen Amplitude, also dessen maximale Stromstärke, beispielsweise kleiner oder gleich 100 A, 200 A, 300 A, 500 A oder 1 kA beträgt. Zweckmäßigerweise ist die Amplitude größer als 0,5 A, 1 A, 5 A, 10 A, 100 A, 150 A, 250 A, 350 A oder 500 A. Vorzugsweise ist die zwischen den Anschlusspunkten anliegende elektrische Spannung größer 100 V, 150 V, 200 V, 250 V, 400 V, 500 V und/oder kleiner 700 V, 690 V, 650 V, 600 V, 500 V oder 350 V.

Beispielsweise ist die erste, zweite und/oder dritte Schutzimpedanz eine kapazitive Impedanz oder bevorzugt ein ohmscher Widerstand. Zweckmäßigerweise weist die erste, zweite und/oder dritte Schutzimpedanz einen vergleichsweise hohen Widerstandswert auf. Insbesondere ist der Widerstandswert größer oder gleich 400 kΩ, 500 kΩ, 600 kΩ, 700 kΩ, 800 kΩ oder 1 MΩ. Zweckmäßigerweise ist der Widerstandswert kleiner oder gleich 3 MΩ, 2,5 MΩ, 2 MΩ, 1,5 MΩ, 1 MΩ, 0,9 MΩ, 0,8 MΩ oder 0,7 MΩ. Auf diese Weise ist ein vergleichsweise geringer elektrischer Stromfluss durch die Schutzimpedanzen in den Diagnosepfad sichergestellt, was einerseits die Dimensionierung sowohl des ersten als auch des zweiten Spannungsmessgeräts vereinfacht. Folglich kann jeweils ein vergleichsweise kostengünstiges Spannungsmessgerät verwendet werden. Andererseits ist auf diese Weise der Wirkungsgrad der elektrischen Heizung aufgrund des Diagnosepfads vergleichsweise gering beeinflusst. Besonders bevorzugt ist der Widerstandswert der ersten, zweiten und dritten Schutzimpedanz gleich. Mit anderen Worten ist der Widerstandswert der ersten Schutzimpedanz gleich dem Widerstandswert der zweiten Schutzimpedanz und dieser wiederum gleich der dritten Schutzimpedanz. Beispielsweise sind die erste, zweite und/oder dritte Schutzimpedanz baugleich. Folglich ist zur Erstellung eines Messwerts, der der über das Heizelement bzw. dem Schalter abfallenden elektrischen Spannung entspricht, keine vergleichsweise komplizierte Berechnung erforderlich. Auch ist bei der Herstellung und Wartung der elektrischen Heizung lediglich eine begrenzte Anzahl unterschiedlicher Bauelemente bereitzuhalten, was die Kosten reduziert.

In einer besonders bevorzugten Ausführungsform ist die erste Schutzimpedanz, insbesondere auf Seiten des ersten Diagnoseabgriffs, mittels einer Impedanz gegen ein Bezugspotential geführt. Mit anderen Worten ist mittels der Impedanz und der ersten Schutzimpedanz ein Widerstandsteiler erstellt. Zweckmäßigerweise ist somit zumindest einer der Eingänge des ersten Spannungsmessgeräts mittels der Impedanz gegen das Bezugspotential geführt. Vorzugsweise ist der Widerstandswert dieser Impedanz vergleichsweise gering, zweckmäßigerweise geringer als 50 kΩ, 40 kΩ, 30 kΩ, 10 kΩ, 5 kΩ oder 1 kΩ. Beispielsweise ist der Widerstandswert größer oder gleich 2 kΩ, 1 kΩ, 800 Ω, 700 Ω, 600 Ω oder 500 Ω. Folglich weist zumindest einer der Eingänge des ersten Spannungsmessgerätes eine vergleichsweise geringe Potentialdifferenz gegenüber dem Bezugspotential auf, so dass ein Kurzschluss gegenüber dem Bezugspotential beispielsweise aufgrund eines Spannungsüberschlages im Wesentlichen nicht möglich ist. Beispielsweise umfasst die elektrische Heizung ein Gehäuse, innerhalb dessen das erste Spannungsmessgerät angeordnet ist, und das auf dem Bezugspotential liegt.

Alternativ oder in Kombination hierzu ist die zweite Schutzimpedanz mittels einer Impedanz gegen das Bezugspotential geführt. Sofern sowohl die erste Schutzimpedanz als auch die zweite Schutzimpedanz gegen das Bezugspotential geführt sind, weist folglich die elektrische Heizung zwei derartige Impedanzen auf. Beispielsweise ist die dritte Schutzimpedanz mittels einer Impedanz gegen das Bezugspotential geführt. Besonders bevorzugt sind sowohl die erste, die zweite, als auch die dritte Schutzimpedanz mittels einer Impedanz gegen das Bezugspotential geführt, wobei der Widerstandswert der jeweiligen Impedanzen geeigneterweise gleich ist. Vorzugsweise sind die Impedanzen baugleich. Zusammenfassend sind folglich vorzugsweise die erste Schutzimpedanz, die zweite Schutzimpedanz und/oder die dritte Schutzimpedanz jeweils auf Seiten des zugeordneten Diagnoseabgriffs mittels der Impedanz gegen das Bezugspotential geführt. Geeigneterweise ist das Bezugspotential Masse, so dass eine Beeinflussung des ersten bzw. zweiten Spannungsmessgeräts aufgrund von Masse im Wesentlichen ausgeschlossen ist. Vorzugsweise ist das erste und/oder zweite Spannungsmessgerät mittels eines aus einem Metall erstellten Gehäuses umgeben, das mit Masse elektrisch verbunden ist. Beispielsweise ist die jeweilige Impedanz eine kapazitive Impedanz oder bevorzugt ein ohmscher Widerstand.

Beispielsweise ist der Schalter ein Relais. Besonders bevorzugt jedoch ist der Schalter ein Halbleiterschalter, was ein Ausbilden eines Lichtbogens beim Schalten eines elektrischen Stroms entlang des Strompfades im Wesentlichen ausschließt. Beispielsweise wird ein MOSFET als Schalter herangezogen. Alternativ ist der Schalter ein Thyristor, so dass nach dem jeweiligen Schaltvorgang kein weiteres Anliegen einer elektrischen Spannung an den jeweiligen Schalteingängen erforderlich ist. Besonders bevorzugt ist der Schalter ein TRIAC. Auf diese Weise ist auch ein Schalten eines Wechselstroms ermöglicht, wobei mit Ausnahme der jeweiligen Schaltvorgänge keine elektrische Spannung zur Ansteuerung erforderlich ist.

Beispielsweise ist das erste Spannungsmessgerät ein Komparator und vorzugsweise ist das zweite Spannungsgerät ein Komparator. Mittels des Komparators wird hierbei lediglich erfasst, ob eine Potentialdifferenz zwischen den einzelnen Eingängen des jeweiligen Spannungsmessgeräts vorliegt. Mit anderen Worten wird mittels des ersten Spannungsmessgeräts ermittelt, ob eine Potentialdifferenz zwischen dem ersten Diagnoseabgriff und dem zweiten Diagnoseabgriff vorliegt. Somit wird die elektrische Spannung lediglich qualitativ und nicht quantitativ ausgewertet. Ebenso wird mittels des zweiten Spannungsmessgeräts ermittelt, ob eine Potentialdifferenz zwischen dem zweiten und dem dritten Diagnoseabgriff vorliegt, also ob eine elektrische Spannung zwischen dem zweiten und dritten Diagnoseabgriff anliegt. Folglich wird mittels des jeweiligen Komparators lediglich ein digitaler Zustand erfasst. Geeigneterweise wird hierbei mittels des jeweiligen Spannungsmessgeräts lediglich eine elektrische Spannung erfasst, die größer als 0,1V, 0,2V, 0,5V oder 1,0V ist.

Insbesondere sind die beiden Komparatoren gegen eine Steuerschaltung geführt, mittels derer der jeweilige Zustand des Komparators ausgewertet wird. Infolgedessen ist vergleichsweise einfach bestimmbar, ob über dem Schalter oder über dem Heizelement eine elektrische Spannung anfällt. Der jeweilige Messwert wird insbesondere mit einer Erwartung verglichen. So wird bei einem leitenden Schalter ein elektrischer Spannungsabfall zwischen dem zweiten und dritten Diagnoseabgriff, jedoch nicht zwischen dem ersten und zweiten Diagnoseabgriff erwartet, wohingegen bei geöffnetem Schalter ein elektrischer Spannungsabfall zwischen dem zweiten und dritten Diagnoseabgriff, jedoch nicht zwischen dem ersten und zweiten Diagnoseabgriff erwartet wird. Bei einer Abweichung hiervon ist ein Fehler identifiziert. Ebenso ist mittels Auswertung der jeweiligen Messwerte eine Stellung des Schalters bestimmbar, sofern diese nicht bekannt ist.

In einer alternativen Ausführung hierzu ist zwischen der jeweiligen Schutzimpedanz und dem zugeordneten Diagnoseabgriff, also zwischen der ersten Schutzimpedanz und dem ersten Diagnoseabgriff, der zweiten Schutzimpedanz und dem zweiten Diagnoseabgriff sowie zwischen der dritten Schutzimpedanz und dem dritten Diagnoseabgriff elektrisch ein A/D-Wandler angeordnet, auch als Analog-Digital-Wandler oder Analog-Digital-Umsetzer bezeichnet. Mit anderen Worten ist zwischen der jeweiligen Schutzimpedanz und dem zugeordneten Diagnoseabgriff ein A/D-Wandler geschaltet. Folglich weist die elektrische Heizung drei A/D-Wandler auf. Mittels jedes A/D-Wandlers wird das jeweilige analoge Messsignal, also das jeweilige Potential, in ein digitales Wort umgewandelt, so dass an dem jeweiligen Diagnoseabgriff ein digitales Wort vorliegt. Zweckmäßigerweise wird dabei die Spannungsdifferenz mittels einer Recheneinheit erstellt, indem das jeweilige digitale Wort von dem hierzu korrespondierenden digitalen Wort abgezogen wird. Zweckmäßigerweise ist das erste und das zweite Spannungsmessgerät innerhalb einer gemeinsamen Recheneinheit integriert, die beispielsweise als integrierte Schaltung (IC) ausgeführt ist. Auf diese Weise ist eine vergleichsweise kompakte elektrische Heizung realisiert, wobei aufgrund der vergleichsweise genau bestimmten anliegenden elektrischen Spannung auch eine Alterung beispielsweise des Schalters oder aber des Heizelements bestimmbar ist. Sofern die gegen das Bezugspotential geführte Impedanz bzw. Impedanzen vorhanden sind, ist diese vorzugsweise mit dem analogen Eingang des jeweiligen A/D-Wandlers elektrisch kontaktiert.

Vorzugsweise umfasst der Strompfad einen vierten Messabgriff sowie eine erste Sicherung, die zwischen dem dritten Messabgriff und dem vierten Messabgriff geschaltet ist. Mit anderen Worten weist der Strompfad in umgekehrter Reihenfolge den vierten Messabgriff, die erste Sicherung, den dritten Messabgriff, den Schalter, den zweiten Messabgriff, das Heizelement und den ersten Messabgriff auf. Ferner umfasst der Diagnosepfad vorzugsweise ein drittes Spannungsmessgerät, das beispielsweise als Komparator oder aber als Recheneinheit, beispielsweise mit einem vorgeschalteten A/D-Wandler, ausgestaltet ist. Insbesondere ist das dritte Spannungsmessgerät baugleich zu dem ersten und/oder zweiten Spannungsmessgerät.

Die erste Sicherung ist vorzugsweise mittels einer vierten Schutzimpedanz, dem dritten Spannungsmessgerät und der dritten Schutzimpedanz überbrückt. Mit anderen Worten ist das dritte Spannungsmessgerät zur ersten Sicherung mittels der vierten Schutzimpedanz und der dritten Schutzimpedanz parallelgeschaltet. Folglich umfasst der Diagnosepfad das dritte Spannungsmessgerät, das zwischen einem vierten Diagnoseabgriff und dem dritten Diagnoseabgriff elektrisch angeordnet ist, wobei der vierte Messabgriff mittels der vierten Schutzimpedanz mit dem vierten Diagnoseabgriff elektrisch kontaktiert ist. Aufgrund der ersten Sicherung ist beispielsweise bei einem Kurzschluss des Heizelements eine Überlastung des Schalters aufgrund eines überhöhten Stromflusses vermieden, wobei die erste Sicherung mittels des dritten Spannungsmessgeräts überwacht wird. Infolgedessen ist ein Ermitteln, ob die erste Sicherung ausgelöst ist, vergleichsweise zeitsparend ermöglicht. Vorzugsweise ist die vierte Schutzimpedanz baugleich zur ersten, zweiten und/oder dritten Schutzimpedanz, oder weist zumindest den gleichen Widerstandswert auf. Insbesondere ist die vierte Schutzimpedanz mittels einer Impedanz gegen das Bezugspotential geführt, wobei die Impedanz z.B. baugleich mit einer Impedanz ist, mittels derer die erste, zweite und/oder dritte Schutzimpedanz gegen das Bezugspotential geführt ist.

Alternativ oder in Kombination hierzu umfasst der Strompfad eine zweite Sicherung, die beispielsweise nicht überbrückt ist. Insbesondere wird die zweite Sicherung optisch von einem Bedienpersonal der Kunststoffformanlage überwacht, oder aber die zweite Sicherung ist mittels einer weiteren Überwachungseinrichtung überwacht. Insbesondere ist der erste Messabgriff hierbei zwischen der zweiten Sicherung und dem Heizelement positioniert, wenn dieses vorhanden ist. Folglich ist der erste Messabgriff ebenfalls zwischen der zweiten Sicherung und dem zweiten Messabgriff angeordnet. Sofern die erste Sicherung vorhanden ist, sind folglich beide Seiten des Schalters sowie des Heizelements mittels einer jeweils zugeordneten Sicherung, nämlich entweder der ersten bzw. der zweiten Sicherung, abgesichert, so dass auch im Falle eines Kurzschlusses mit Masse oder Erde ein Stromfluss unterbrochen wird.

Beispielsweise ist zwischen dem zweiten Messabgriff und dem dritten Messabgriff eine dritte Sicherung geschaltet, insbesondere in Reihe zu dem Schalter. Vorzugsweise ist die dritte Sicherung elektrisch zwischen dem Schalter und dem dritten Messabgriff angeordnet. Die Verwendung der dritten Sicherung ist hierbei unabhängig von dem Vorhandensein der ersten und/oder zweiten Sicherung.

Das Verfahren zum Betrieb einer elektrischen Heizung mit einem Strompfad, das einen in Reihe mit einem Heizelement schaltbaren Schalter aufweist, der mittels einer dritten Schutzimpedanz, einem zweiten Strommessgerät und einer zweiten Schutzimpedanz überbrückt ist, wobei das Heizelement oder ein Anschluss für ein Heizelement mittels der zweiten Schutzimpedanz, einem ersten Spannungsmessgerät und einer ersten Schutzimpedanz überbrückt ist, sieht vor, dass in einem ersten Arbeitsschritt mittels des ersten Spannungsmessgeräts ein erster Messwert und mittels des zweiten Spannungsmessgeräts ein zweiter Messwert erstellt wird. Vorzugsweise erfolgt die Erstellung der beiden Messwerte zeitgleich.

In einem weiteren Arbeitsschritt werden die beiden Messwerte mit einer Tabelle verglichen, innerhalb derer insbesondere Erwartungswerte für die beiden Messwerte abgespeichert sind. Anhand des Vergleichs wird zweckmäßigerweise der Zustand der elektrischen Heizung ermittelt. Beispielsweise ist innerhalb der Tabelle hinterlegt, dass bei einem nicht verschwindenden ersten Messwert und einem zweiten Messwert, der im Wesentlichen "Null" entspricht, ein ordnungsgemäßer Betrieb des Heizelements vorliegt. Alternativ oder in Kombination hierzu ist in der Tabelle hinterlegt, dass bei einem verschwindenden ersten Messwert und einem zweiten Messwert, der verschieden von Null ist, eine Unterbrechung des Stromflusses mittels des Schalters vorliegt.

Nachfolgend werden Ausführungsbeispiele der Erfindung anhand einer Zeichnung näher erläutert. Darin zeigen:
- FIG 1: Schematisch eine erste Ausführungsform einer elektrischen Heizung,
- FIG 2: eine weitere Ausführungsform gemäß FIG 1, und
- FIG 3: ein Verfahren zum Betrieb der elektrischen Heizung gemäß FIG 1 oder FIG 2.

Einander entsprechende Teile sind in allen Figuren mit den gleichen Bezugszeichen versehen.

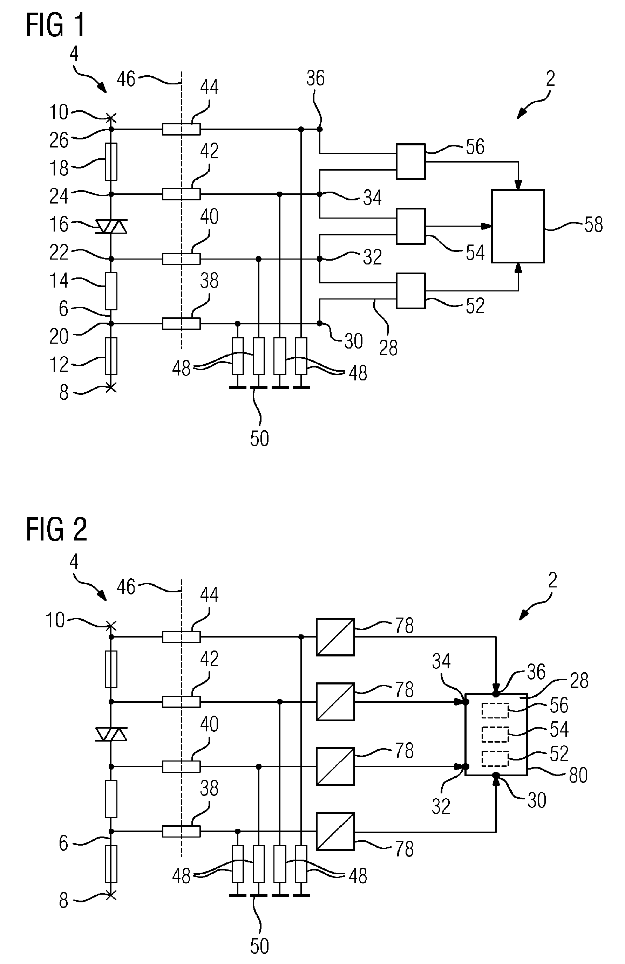

In FIG 1 ist schematisch ausschnittsweise eine Kunststoffformanlage 2 dargestellt, mittels derer PET-Flaschen erstellt werden. Die Kunststoffformanlage 2 umfasst eine elektrische Heizung 4, mittels derer der Kunststoff erwärmt wird, der in einem weiteren Arbeitsschritt mittels nicht gezeigter Formen in Flaschenform gebracht wird. Die elektrische Heizung 4 umfasst einen Strompfad 6 mit einem ersten Anschlusspunkt 8 und einem zweiten Anschlusspunkt 10, die die Endpunkte des Strompfades 10 bilden. Der erste und der zweite Anschlusspunkt 8, 10 sind elektrisch mit einer Wechselstromquelle mit 300 A kontaktiert, wobei jeder Anschlusspunkt 8, 10 mit einem Pol der Stromquelle elektrisch leitend verbunden ist.

Zwischen dem ersten und dem zweiten Anschlusspunkt 8, 10 ist eine zweite Sicherung 12 ein Heizelement 14, ein elektrischer Schalter 16 in Form eines TRIAC sowie eine erste Sicherung 18 in Reihe geschaltet. Hierbei ist zwischen der zweiten Sicherung 12 und dem Heizelement 14 ein erster Messabgriff 20 zwischen dem Heizelement 14 und dem Schalter 16 ein zweiter Messabgriff 22, zwischen dem Schalter 16 und der ersten Sicherung 18 ein dritter Messabgriff 24 sowie zwischen der ersten Sicherung 18 und dem zweiten Anschlusspunkt 10 ein vierter Messabgriff 26 elektrisch angeordnet. Infolgedessen fließt bei geschlossenem Schalter 16 ein elektrischer Strom von dem ersten Anschlusspunkt 8 über die zweite Sicherung 12, den ersten Messabgriff 20, das Heizelement 14, den zweiten Messabgriff 22, den Schalter, den dritten Messabgriff 24, die erste Sicherung 18 und den vierten Messabgriff 26 zu dem zweiten Anschlusspunkt 10.

Die elektrische Heizung 4 umfasst ferner einen Diagnosepfad 28 mit einem ersten Diagnoseabgriff 30, einem zweiten Diagnoseabgriff 32, einem dritten Diagnoseabgriff 34 und einem vierten Diagnoseabgriff 36, die in Reihe geschaltet sind. Hierbei ist der erste Messabgriff 20 mittels einer ersten Schutzimpedanz 38 mit dem ersten Diagnoseabgriff 30 elektrisch kontaktiert. Der zweite Messabgriff 22 ist mittels einer zweiten Schutzimpedanz 40 mit dem zweiten Diagnoseabgriff 32, der dritte Messabgriff 24 mittels einer dritten Schutzimpedanz 42 mit dem dritten Diagnoseabgriff 34 sowie der vierte Messabgriff 26 mittels einer vierten Schutzimpedanz 44 mit dem vierten Diagnoseabgriff 36 elektrisch kontaktiert. Hierbei ist der Widerstandswert der ersten, zweiten, dritten und vierten Schutzimpedanz 38, 40, 42, 44 jeweils gleich und beträgt 1 MΩ. Die erste, zweite, dritte, vierte Schutzimpedanz 38, 40, 42, 44 sind hierbei die einzige elektrische Verbindung zwischen dem Strompfad 6 und dem Diagnosepfad 28 und bilden folglich einen Impedanzwall 46, mittels dessen ein Stromfluss von dem Strompfad 6 zum Diagnosepfad 28 auf einen vergleichsweise geringen Wert reduziert ist.

Die elektrische Heizung 4 weist ferner vier gleichartige Impedanzen 48 auf, die jeweils gegen ein Bezugspotential 50, nämlich Masse geführt sind. Der Widerstandswert der Impedanzen 48 beträgt 2 kΩ. Jede der Impedanzen 48 ist ferner mit einem der Diagnoseabgriffe 30, 32, 34, 36 elektrisch kontaktiert, so dass diese aufgrund des vergleichsweise geringen Widerstandswertes der Impedanzen 48 lediglich eine geringe Potentialdifferenz zu dem Bezugspotential 50 aufweisen. Folglich ist die erste, zweite, dritte und vierte Schutzimpedanz 38, 40, 42, 44 mittels der jeweiligen Impedanz 48 gegen das Bezugspotential 50 geführt.

Zwischen dem ersten Diagnoseabgriff 30 und dem zweiten Diagnoseabgriff 32 ist ein erstes Spannungsmessgerät 52, zwischen dem zweiten Diagnoseabgriff 32 und dem dritten Diagnoseabgriff 34 ein zweites Spannungsmessgerät 54 und zwischen dem dritten Diagnoseabgriff 34 und dem vierten Diagnoseabgriff 36 ein drittes Spannungsmessgerät 56 elektrisch geschaltet. Die Spannungsmessgeräte 52, 54, 56 sind jeweils als Komparatoren ausgestaltet, mittels derer lediglich eine Spannungsdifferenz zwischen den jeweiligen Diagnoseabgriffen 30, 32, 34, 36 ermittelt wird, zwischen denen das jeweilige Spannungsmessgerät 53, 54, 56 geschaltet ist. So ist mittels des ersten Spannungsmessgeräts 52 lediglich eine Potentialdifferenz zwischen dem ersten Diagnoseabgriff 30 und dem zweiten Diagnoseabgriff 32 ermittelbar. Hierbei ist beispielsweise erst eine Potentialdifferenz größer 0,2 V mittels der jeweiligen Spannungsmessgeräte 52, 54, 56 erfassbar. Mit anderen Worten wird mittels der Spannungsmessgeräte 52, 54, 56 erst eine Potentialdifferenz größer oder gleich 0,2 V als bestehende Spannung erfasst. Die Spannungsmessgeräte 52, 54, 56 sind gegen eine Steuerschaltung 58 geführt, mittels derer die mittels der Spanungsmessgeräte 53, 54, 56 erstellten binären Messwerte ausgewertet werden.

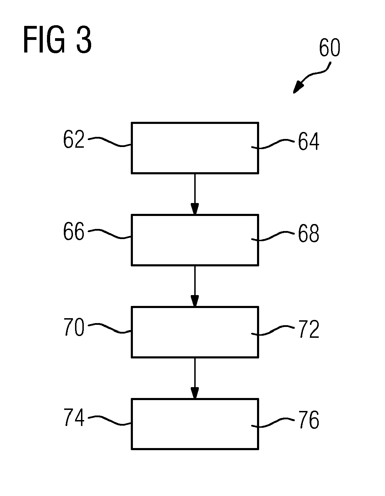

Bei Betrieb der elektrischen Heizung 4 wird ein in FIG 3 dargestelltes Verfahren 60 durchgeführt. Zunächst wird der Schalter 16 derart angesteuert, dass ein Stromfluss zwischen dem ersten und zweiten Anschlusspunkt 8, 10 erfolgt. Mit anderen Worten wird der Schalter 16 geschlossen, woraufhin ein Wechselstrom über den Strompfad 6 mit einer Stromstärke von 200 A fließt. Infolgedessen wird das Heizelement 14, das mittels eines Heizwiderstandes gebildet ist, erwärmt. Zudem wird in einem ersten Arbeitsschritt 62 mittels des ersten Spannungsmessgeräts 52 ein erster Messwert 64 erstellt und der Steuerschaltung 58 zugeführt. Hierbei wird ermittelt, ob eine Potentialdifferenz zwischen dem ersten Diagnoseabgriff 30 und dem zweiten Diagnoseabgriff 32 besteht, wobei etwaige Nulldurchgänge aufgrund der Frequenz des Wechselstroms nicht berücksichtigt werden. Der erste Messwert 64 entspricht folglich entweder dem Wert "0", was einer zwischen den beiden Diagnoseabgriffen 30, 32 herrschenden elektrischen Spannung unter 0,2 V entspricht oder aber "1", was einer elektrischen Spannung oberhalb von 0,2 V entspricht.

Zeitgleich wird in einem zweiten Arbeitsschritt 66 mittels des zweiten Spannungsmessgeräts 54 ein zweiter Messwert 68 erstellt, der in gleicher Weise wie der erste Messwert 64 gebildet ist. Ebenso wird in einem zeitgleichen dritten Arbeitsschritt 70 ein dritter Messwert 72 mittels des dritten Spannungsmessgeräts 56 in gleicher Weise gebildet. Die drei Messwerte 74, 68, 72 werden der Steuerschaltung 58 in einem vierten Arbeitsschritt 64 zugeführt und mit einer dort hinterlegten Tabelle 76 verglichen. Innerhalb der Tabelle 76 ist hinterlegt, dass bei einem ersten Messwert 64 von "0", einem zweiten Messwert 68 "0" und einem dritten Messwert 72 von "1", im Weiteren als "0,0,1" bezeichnet, wobei die erste Stelle den ersten Messwert 64, die zweite Stelle den zweiten Messwert 68 und die dritte Stelle den dritten Messwert 72 bezeichnet, die erste Sicherung 18 beschädigt ist. Auch ist in der Tabelle 76 hinterlegt, dass bei einem Wert von "0,1,0" der Schalter 16 geöffnet ist, und dass bei einem Wert von "1,0,0" das Heizelement 14 korrekt arbeitet.

In FIG 2 ist eine weitere Ausführungsform der Kunststoffformanlage 2 mit der elektrischen Heizung 4 dargestellt. Der Strompfad 6 ist hierbei unverändert belassen. Auch entsprechen die erste, zweite, dritte, vierte Schutzimpedanz 38, 40, 42, 44 und deren elektrische Kontaktierung mit dem Strompfad 6 denen des ersten Ausführungsbeispiels. Auch sind die Schutzimpedanzen 38, 40, 42, 44 jeweils mittels der zugeordneten Impedanzen 48 gegen Masse 50 geführt.

Die elektrische Heizung 4 weist jedoch im Unterschied zur vorhergehenden Ausführungsform vier A/D-Wandler 78 auf, von denen jeweils einer zwischen den Schutzimpedanzen 38, 40, 42, 44 und den zugeordneten Diagnoseabgriff 30, 32, 34, 36 elektrisch geschaltet ist. Mit anderen Worten ist einer der A/D-Wandler 78 zwischen der ersten Schutzimpedanz 38 und dem ersten Diagnoseabgriff 30, einer der A/D-Wandler 78 zwischen der zweiten Schutzimpedanz 40 und dem zweiten Diagnoseabgriff 32, einer der A/D-Wandler 78 zwischen der dritten Schutzimpedanz 42 und dem dritten Diagnoseabgriff 34 und der verbleibende A/D-Wandler 78 zwischen der vierten Schutzimpedanz 44 und dem vierten Diagnoseabgriff 36 angeordnet.

Mittels der AD-Wandler 78 wird der seitens der jeweiligen Schutzimpedanz 38, 40, 42, 44 vorliegende analoge Potentialwert in ein digitales Wort umgewandelt und dem jeweiligen Diagnoseabgriff 30, 32, 34, 36 zugeleitet. Diese digitalen Worte werden mittels des ersten, zweiten und dritten Spannungsmessgeräts 52, 54, 56 miteinander verglichen, wobei die digitalen Worte voneinander abgezogen werden. Hierbei ist das erste, zweite und dritte Strommessgerät 52, 54, 56 mittels einer gemeinsamen Recheneinheit 80 gebildet, die als integrierter Schaltkreis vorliegt. Die Recheneinheit 80 bildet hierbei auch den Diagnosepfad 28.

Der Betrieb dieser Ausführungsvariante der elektrischen Heizung 4 erfolgt ebenfalls entsprechend dem Verfahren 60, wobei die Tabelle 76 jedoch vergrößert ausgeführt ist, und nicht lediglich qualitative, sondern auch quantitative Werte umfasst. Bei beiden Ausführungsvarianten der elektrischen Heizung 4 jedoch sind aufgrund der Kaskadierung der einzelnen Strommessgeräte 52, 54, 56 sowohl die Kosten zur Herstellung verringert als auch ein Betrieb erleichtert.

Die Erfindung ist nicht auf die vorstehend beschriebenen Ausführungsbeispiele beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit den einzelnen Ausführungsbeispielen beschriebene Einzelmerkmale auch auf andere Weise miteinander kombinierbar, ohne den Gegenstand der Erfindung zu verlassen.

## Patentansprüche

1. Elektrische Heizung (4), insbesondere einer Kunststoffformanlage (2), mit einem Strompfad (6), der einen ersten Messabgriff (20), einen zweiten Messabgriff (22), einen Schalter (16) und einen dritten Messabgriff (24) aufweist, die in Reihe geschaltet sind, wobei zwischen den ersten Messabgriff (20) und den zweiten Messabgriff (22) ein Heizelement (14) schaltbar ist, und mit einem Diagnosepfad (28), der einen ersten Diagnoseabgriff (30), ein erstes Spannungsmessgerät (52), einen zweiten Diagnoseabgriff (32), ein zweites Spannungsmessgerät (54) und einen dritten Diagnoseabgriff (34) aufweist, die in Reihe geschaltet sind, wobei der erste Messabgriff (20) mittels einer ersten Schutzimpedanz (38) mit dem ersten Diagnoseabgriff (30), der zweite Messabgriff (22) mittels einer zweiten Schutzimpedanz (40) mit dem zweiten Diagnoseabgriff (32) und der dritte Messabgriff (24) mittels einer dritten Schutzimpedanz (42) mit dem dritten Diagnoseabgriff (34) elektrisch kontaktiert ist.

2. Elektrische Heizung (4) nach Anspruch 1, **dadurch gekennzeichnet, dass** der Widerstandswert der ersten, zweiten und dritten Schutzimpedanz (38, 40, 42) gleich ist.

3. Elektrische Heizung (4) nach Anspruch 1 oder 2, **dadurch gekennzeichnet, dass** die erste Schutzimpedanz (38), die zweite Schutzimpedanz (40) und/oder die dritte Schutzimpedanz (42) mittels einer Impedanz (48) gegen ein Bezugspotential (50) geführt ist.

4. Elektrische Heizung (4) nach Anspruch 3, **dadurch gekennzeichnet, dass** das Bezugspotential (50) Masse ist.

5. Elektrische Heizung (4) nach einem der Ansprüche 1 bis 4, **dadurch gekennzeichnet, dass** der Schalter (16) ein TRIAC ist.

6. Elektrische Heizung (4) nach einem der Ansprüche 1 bis 5, **dadurch gekennzeichnet, dass** das erste und zweite Spannungsmessgerät (52, 54) jeweils ein Komparator ist, die insbesondere gegen eine Steuerschaltung (58) geführt sind.

7. Elektrische Heizung (4) nach einem der Ansprüche 1 bis 5, **dadurch gekennzeichnet, dass** zwischen den Schutzimpedanzen (38, 40, 42) und dem zugeordneten Diagnoseabgriff (30, 32, 34) jeweils ein A/D-Wandler (78) geschaltet ist, wobei das erste und zweite Spannungsmessgerät (52, 54) insbesondere mittels einer gemeinsamen Recheneinheit (80) gebildet ist.

8. Elektrische Heizung (4) nach einem der Ansprüche 1 bis 7, **dadurch gekennzeichnet, dass** der Strompfad (6) einen vierten Messabgriff (26) und eine zwischen den vierten Messabgriff (26) und den dritten Messabgriff (24) geschaltete erste Sicherung (18) aufweist, wobei der vierte Messabgriff (26) mittels einer vierten Schutzimpedanz (44) mit einem vierten Diagnoseabgriff (36) des Diagnosepfads (28) elektrisch kontaktiert ist, zwischen dem und dem dritten Diagnoseabgriff (34) ein drittes Spannungsmessgerät (56) geschaltet ist.

9. Elektrische Heizung (4) nach einem der Ansprüche 1 bis 8, **dadurch gekennzeichnet, dass** der Strompfad (6) eine zweite Sicherung (12) aufweist, wobei der erste Messabgriff (20) insbesondere zwischen die zweite Sicherung (12) und das Heizelement (14) bzw. den zweiten Messabgriff (22) geschaltet ist.

10. Verfahren (60) zum Betrieb einer elektrische Heizung (4) nach einem der Ansprüche 1 bis 9, bei dem mittels des ersten Spannungsmessgeräts (52) ein erster Messwert (64) und mittels des zweiten Spannungsmessgeräts (54) ein zweiter Messwert (68) erstellt wird, und die beiden Messwerte (64, 68) mit einer Tabelle (76) verglichen werden.
